# EUROPÄISCHE PATENTSCHRIFT

(11) **EP 0 688 106 B1**
(45) Veröffentlichungstag und Bekanntmachung des Hinweises auf die Patenterteilung: **16.01.2002**
(21) Anmeldenummer: 95108072.0
(22) Anmeldetag: 26.05.1995
(51) Int. Cl.: G06F 11/10, G06F 11/16, G11C 8/00, H03M 13/00

(54) **Dekoder**
Decoder
Décodeur

(30) Priorität: 16.06.1994 DE 4420963; 23.07.1994 DE 4426220
(43) Veröffentlichungstag der Anmeldung: 20.12.1995
(73) Patentinhaber: ROBERT BOSCH GMBH, 70442 Stuttgart (DE)
(72) Erfinder: Boehl, Eberhard, Dr., D-72768 Reutlingen (DE)

(56) Entgegenhaltungen:
- EP-A- 0 444 407
- US-A- 4 337 525
- US-A- 4 486 883
- PATENT ABSTRACTS OF JAPAN vol. 13 no. 74 (E-717) [3422] ,20.Februar 1989 & JP-A-63 254821 (NEC) 21.Oktober 1988,

## Beschreibung

### Stand der Technik

Die Erfindung geht aus von einem Dekoder nach der Gattung des unabhängigen Anspruchs 1. Es sind bereits Dekoder bekannt, bei denen aufgrund von an der Adreßleitung anliegenden Signalen eine Ausgangsleitung angesteuert wird. Dazu werden invertierte und nichtinvertierte Signale der Adreßleitungen an Gatter angelegt. Zur Überprüfung der Signale wird neben den Adreßbits mindestens ein weiteres Prüfbit, beispielsweise ein Paritätsbit vorgesehen, welches zur Kontrolle der anliegenden Adreßsignale dient. Bei bestimmten Störungen, insbesondere bei Kurzschlüssen zwischen zwei Leitungen, die auf unterschiedlichem Pegel liegen, kann es vorkommen daß es zu einer fehlerhaften Ansteuerung einer oder mehrerer Ausgangsleitungen kommt, ohne daß dieser Fehler anhand des Prüfbits festgestellt werden kann.

### Vorteile der Erfindung

Der erfindungsgemäße Dekoder mit den kennzeichnenden Merkmalen des unabhängigen Anspruchs 1 hat demgegenüber den Vorteil, daß fehlerhafte Adreßsignale besser erkannt werden können. Der dazu benötigte Mehraufwand wird gering gehalten.

Durch die in den abhängigen Ansprüchen aufgeführten Maßnahmen sind vorteilhafte Weiterbildungen und Verbesserungen des im unabhängigen Anspruch angegebenen Dekoders möglich. Zweckmäßigerweise erhält der Kodeprüfer alle Signale, die an den Adreßleitungen anliegen. Ein besonders einfaches Beispiel eines Kodeprüfers besteht in der Überprüfung eines Paritätsbits. Durch die Anordnung eines Pegelwandlers vor dem Kodeprüfer wird erreicht, daß alle fehlerhaften Pegel an den Eingängen der Gatter, die zu einer fehlerhaften Adressierung führen, zuverlässig erkannt werden, insbesondere, wenn von den Ausgangsleitungen des Dekoders immer genau eine Leitung aktiv sein soll und das fehlerhafte Aktivieren von zwei Dekoder-Ausgangsleitungen durch eine zusätzliche Prüfschaltung erkannt wird. Als zusätzliche Prüfschaltung sind allgemein bekannte Anordnungen wie z.B. in Wakerly, J.: Error Detecting Codes, Self Checking Circuits and Applications, Elsevier, North-Holland 1978, Toy, W.N.: Modular LSI Control and Logic Design with Error Detection, IEEE Trans.Comp., Vol. C-20, No.2, pp. 161-166, Febr.1971 oder Carter, W.C. Duke, K.A. Jessep, D.C.: A simple self-testing decoder checking circuit, IEEE Trans.Comp. Vol. C-20, No.11, pp. 1413-1414, Nov. 1971. Die einfachste Ausgestaltung eines derartigen Pegelwandlers besteht in einem Inverter.

### Zeichnungen

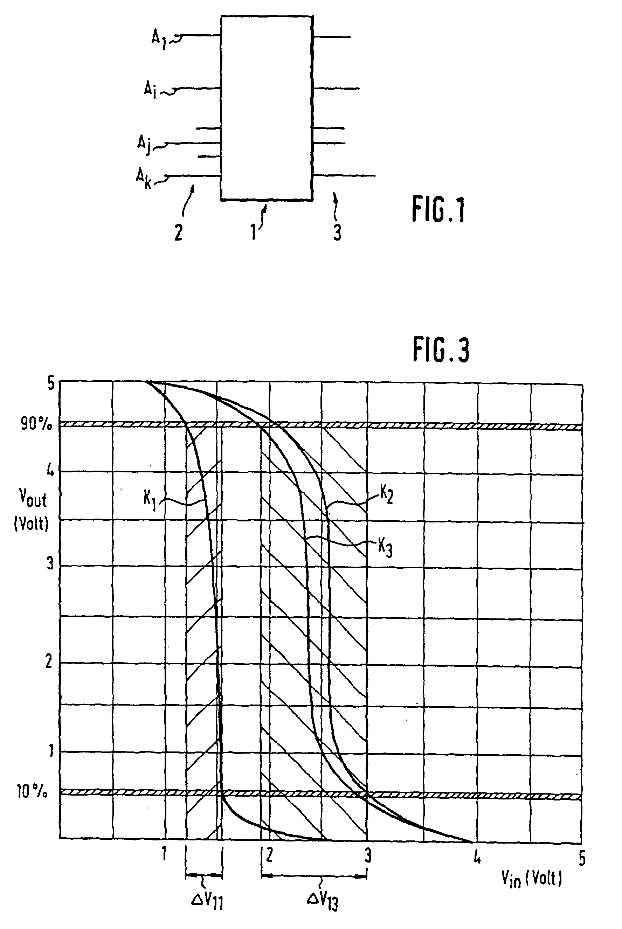

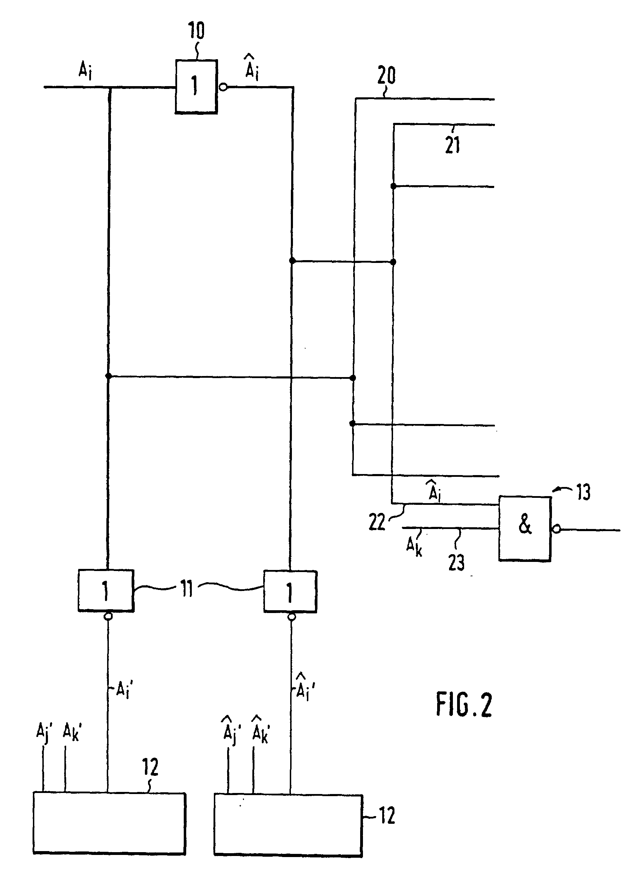

Ausführungsbeispiele der Erfindung sind in den Zeichnungen dargestellt und in der nachfolgenden Beschreibung näher erläutert. Es zeigen Figur 1 eine schematische Darstellung eines Dekoders, Figur 2 die Ausgestaltung des erfindungsgemäßen Dekoders und Figur 3 zeigt das Schaltverhalten der in Figur 2 verwandten Gatter und Pegelwandler.

### Beschreibung des Ausführungsbeispiels

In der Figur 1 ist schematisch ein Dekoder 1 gezeigt. Der Dekoder 1 weist Eingangsleitungen 2 auf, an die Adreßsignale A₁ ... Aᵢ, Aⱼ ... Aₖ angelegt sind. In Abhängigkeit von den an den Eingangsleitungen 2 anliegenden Eingangssignalen wird eine der Ausgangsleitungen 3 angesteuert. Die Eingangsleitungen 2 können jeweils den Schaltzustand high und low annehmen. Ebenso können die Ausgangsleitungen 3 jeweils den Zustand high oder low annehmen. In Abhängigkeit von den an den Eingangsleitungen anliegenden Signalen A₁ ... Aₖ wird eine der Ausgangsleitungen 3 angesprochen, d.h. sie weist beispielsweise als einzige Leitung den Zustand high auf, während alle anderen Ausgangsleitungen 3 den Zustand low aufweisen.

In der Figur 2 wird nun die Verarbeitung eines einzelnen Eingangssignals Aᵢ im Inneren des Dekoders 1 gezeigt. Die Leitung, die mit dem Signal Aᵢ beaufschlagt ist, ist mit einem Inverter 10 verbunden, der aus dem Signal Aᵢ das invertierte Signal Âᵢ bildet. Die beiden Signale Aᵢ und Âᵢ werden dann über weitere Leitungen 20, 21 und 22 an Gatter weitergegeben. Exemplarisch wird ein einzelnes Nand-Gatter 13 gezeigt, welches über die Leitung 22 mit dem invertierten Signal Âᵢ beaufschlagt wird. Das Gatter 13 weist noch mehrere Eingänge auf, an denen jeweils nichtinvertierte (A₁ ... Aₖ) und invertierte (Â₁ ... Âₖ) Signale anliegen. Exemplarisch wird hier nur eine weitere Leitung 23 gezeigt, an der das Signal Aₖ anliegt. Weiterhin sind die Leitungen, an denen das nichtinvertierte Signal Aᵢ und das invertierte Signal Âᵢ anliegen mit einem Kodeprüfer 12 verbunden. In der Figur 2 erfolgt dies über die Pegelwandler 11, die aus den Signalen Aᵢ und Âᵢ jeweils ein Signal Aᵢ' und Âᵢ' bilden.

Die Kodeprüfer 12 weisen weiterhin Eingänge auf, an denen die Signale der anderen Eingänge A₁ ... Aₖ bzw. davon abgeleitete d.h. invertierte oder pegelgewandelte Signale anliegen. Auch wenn andere Formen der Kodeprüfung vorstellbar sind, soll im weiteren davon ausgegangen werden, daß es sich bei dem Kodeprüfer 12 um einen Paritätsprüfer handelt.

Die Kodeprüfer 12 werden dazu verwandt, fehlerhafte Signale an den Eingängen der Gatter 13 zu erkennen. Im folgenden wird beispielsweise davon ausgegangen, daß zwischen der Leitung 22 und der Leitung 23 am Eingang des Gatters 13 ein Kurzschluß existiert. Wenn nun die beiden Leitungen 22 und 23 auf einem unterschiedlichen Pegel liegen, so wird durch den Kurzschluß der Pegel auf der Leitung 22, 23 beeinflußt. Das Signal Âᵢ wird ggf. so verfälscht, daß es zu einer Fehlermeldung im Kodeprüfer 12 führt. Bei einer direkten Verbindung des Kodeprüfers 12 mit den Leitungen, die das nichtinvertierte Signale Aᵢ bzw. das invertierte Signal Âᵢ führen, können so Kurzschlußfehler in den Leitungen erkannt werden, die zu fehlerhaften Low- oder High-Zuständen auf Gatterleitungen führen. Erkennt der Kodeprüger kein falsches Signal, so ist entweder gewährleistet, daß das richtige Dekoderausgangssignal aktiv ist (dann liegt kein Fehler vor) oder daß neben dem richtigen Dekoderausgangssignal noch ein anderes Dekoderausgangssignal aktiv ist. Diesen Fehler muß man durch einen zusätzlichen Prüfer erkennen (nicht dargestellt). Dazu sind Methoden bekannt( Wakerly, J.: Error Detecting Codes, Self Checking Circuits and Applications, Elsevier, North-Holland 1978, Toy, W.N.: Modular LSI Control and Logic Design with Error Detection, IEEE Trans.Comp., Vol. C-20, No.2, pp. 161-166, Febr.1971 oder Carter, W.C. Duke, K.A. Jessep, D.C.: A simple self-testing decoder checking circuit, IEEE Trans.Comp. Vol. C-20, No.11, pp. 1413-1414, Nov. 1971).

Durch einen Kurzschluß zwischen den Leitungen 22 und 23 können jedoch auch Pegel auf den Leitungen auftreten, die nicht eindeutig einem High- oder einem Low-Zustand zugeordnet werden können. Da die Gatter 13 und auch die Kodeprüfer 12 mit Fertigungstoleranzen versehen sind, kann es dabei zu einem Pegel kommen, der vom Kodeprüfer 12 nicht als fehlerhaft erkannt wird und trotzdem die Gatter 13 fehlerhaft ansteuert. Derartige Pegel, die nicht eindeutig einem High- oder Low-Zustand zugeordnet werden können, sind beispielsweise zu erwarten, wenn der Dekoder in CMOS-Technik realisiert sind. Um derartige Pegel trotzdem zuverlässig zu erkennen, sind den Kodeprüfern 12 Pegelwandler 11 vorgeordnet, durch die die Eingangspegel der Signal Aᵢ bzw. Âᵢ verschoben werden.

In der Figuur 3 werden die unterschiedlichen Schaltpegel der Pegelwandler 11 bzw. der Gatter 13 erläutert. Die Kurve 1 zeigt dabei das Schaltverhalten des Pegelwandlers 1. Wie zu erkennen ist, sind die Pegelwandler 11 als Inverter 11 ausgebildet. In den Kurven 2 und 3 wird das Schaltverhalten von zwei unterschiedlichen Nand-Gattern gezeigt, die jeweils die Obergrenze und Untergrenze der Fertigungsstreuung verdeutlichen. Den Pegelwandlern 11 läßt sich somit ein Schaltbereich ΔV₁₁ und den Nand-Gattern 13 ein Schaltbereich ΔV₁₃ zuordnen. Das Schaltverhalten der Pegelwandler 11 bzw. der Gatter 13 ist eindeutig, sofern der Eingangsspannungspegel (x-Achse) unterhalb von ΔV₁₁ bzw.
ΔV₁₃ bzw. oberhalb von ΔV₁₁ bzw. ΔV₁₃ ist. Von wesentlicher Bedeutung ist hier, daß sich die Spannungsbereiche ΔV₁₁ und ΔV₁₃ nicht überlappen. Auf diese Weise wird sichergestellt, daß ein fehlerhafter Low-Zustand der Signale Aᵢ oder Âᵢ eindeutig erkannt wird. Wenn aufgrund eines Kurzschlusses eine Leitung, die auf Null gelegt sein sollte. Auf einen etwas höheren Spannungspegel gezogen wird, so führt dies zu einem eindeutigen Schaltverhalten der Pegelwandler 11, sobald die Spannung größer als ΔV₁₁ wird. Da das Ausgangssignal Aᵢ' bzw. Âᵢ' dann eindeutig fehlerhaft ist, können die als Paritätsprüfer ausgebildeten Kodeprüfer 12 einen Fehler eindeutig feststellen. Wenn sich die beiden Schaltbereiche ΔV₁₁ und ΔV₁₃ überlappen würden, könnte es, falls sich ein Spannungspegel im Überlappungsbereich einstellt, zu einer fehlerhaften Ansteuerung eines Gatters 13 kommen, ohne daß dies von den Kodeprüfern 12 erkannt würde. Da sich die Schaltbereiche jedoch nicht überlappen, ist dieser Fall eindeutig ausgeschlossen.

Durch entsprechend ausgelegte Pegelwandler 11, deren Schaltbereich ΔV₁₁ zu höheren Spannungen als der Schaltbereich der Gatter 13 verschoben ist, läßt sich entsprechend ein Aufbau denken, bei dem fehlerhafte High-Pegel erkannt werden. Da jedoch bei einem Kurzschluß zwischen einer Leitung mit einem High-Signal und einer Leitung mit einem Low-Signal jeweils ein fehlerhaftes Low- und ein fehlerhaftes High-Signal entstehen, ist für einen Kurzschluß zwischen zwei Leitungen der Nachweis eines dieser Signale ausreichend. Weiterhin werden durch den gezeigten Aufbau alle Fehler erkannt, die aus anderen Gründen zu einem fehlerhaften Low- bzw einem fehlerhaften High-Signal führen.

Neben dem hier gezeigten Aufbau erschließen sich dem Fachmann eine Reihe von naheliegenden Variationen. So müssen beispielsweise die Pegelwandler 11 nicht zwingend als Inverter ausgebildet sein, sondern es sich beliebige Schaltelemente möglich, deren Schaltpegel sich nicht mit dem Schaltpegel der Gatter 13 überlappt. Neben dem als Paritätsprüfer ausgebildeten Kodeprüfer 12 sind auch andere Möglichkeiten der Kodeprüfung denkbar, insbesondere, wenn mehr als ein Prüfbit benutzt wird. Ebenso sind statt der Nand-Gatter 13 andere Anordnungen von Gattern, die zu einer Dekodierung führen möglich. Das können beispielsweise NOR-Gatter sein. Es ist jedoch darauf zu achten, daß in einem Dekoder möglichst immer gleichartige Elemente 13 eingesetzt werden, da nur dann der gleiche Schaltbereich ΔV₁₃ garantiert werden kann und der gleiche logische Pegel der Leitungen 20 23 das Gatter 13 aktiviert.

Die Erkennung von fehlerhaften Schaltpegeln erfolgt hier besonders einfach, indem der sowieso zur Überprüfung des Paritätsbits verwendeten Paritätsprüfer 12 mit herangezogen wird. Der zusätzliche Aufwand von zwei Pegelwandlern 11, die zudem besonders einfach als Inverter ausgebildet sind pro Adreßbit ist besonders gering. Durch das Zusammenwirken der Pegelwandler 11 mit den Kodeprüfern 12 wird ein Aufbau geschaffen, der während eines Arbeitstaktes überprüft, ob alle an den Gattern 13 anliegenden Schaltpegel eindeutig high oder eindeutig low sind. Ebensogut ist auch ein Spannungssensor vorstellbar, der während des Arbeitstaktes die Spannungspegel auf den Leitungen überprüft.

## Patentansprüche

1. Dekoder, der aufgrund von an Adreßleitungen (2) anliegenden Signalen (A₁...Aₖ) eine Ausgangsleitung (3) ansteuert, wobei die an den Adreßleitungen anliegenden Signale (A₁...Aₖ) teilweise invertiert (Â₁...Âₖ) und teilweise nichtinvertiert (A₁...Aₖ) an Gatter (13) angelegt werden, **dadurch gekennzeichnet, daß** die invertierten (Âᵢ ...Âₖ) und nichtinvertierten (A₁...Aₖ) Signale jeweils mit einem Kodeprüfer (12) überprüft werden.

2. Dekoder nach Anspruch 1, **dadurch gekennzeichnet, daß** der Kodeprüfer (12) als Paritätsprüfer ausgebildet ist.

3. Dekoder nach einem der vorhergehenden Ansprüche, **dadurch gekennzeichnet, daß** den Kodeprüfern (12) ein Pegelwandler (11) vorgeordnet ist, daß der Pegelwandler (11) unterhalb eines vorgegebenen Spannungsbereichs das Eingangssignals als low und oberhalb des vorgegebenen Spannungsbereichs ΔV₁₁ als high auffaßt, daß der Pegelwandler (11) als Ausgangssignal ein Low- oder High-Signal an den Kodeprüfer (12) weitergibt, daß die Gatter (13) unterhalb eines vorgegebenen Spannungsbereichs ΔV₁₃ ein Signal als low und oberhalb des vorgegebenen Spannungsbereichs ΔV₁₃ als high verstehen, und daß sich der Spannungsbereich ΔV₁₁ der Pegelwandler und Spannungsbereich ΔV₁₃ der Gatter (13) nicht überschneiden.

4. Dekoder nach Anspruch 3, **dadurch gekennzeichnet, daß** die Pegelwandler (11) als Inverter ausgebildet sind.

## Claims

1. Decoder which drives an output line (3) on the basis of signals (A₁...Aₖ) applied to address lines (2), where the signals (A₁...Aₖ) applied to the address lines are applied, some in inverted form (Â₁...Âₖ) and some in uninverted form (A₁...Aₖ), to gates (13), **characterized in that** the inverted signals (Âᵢ...Âₖ) and the uninverted signals (A₁...Aₖ) are respectively checked using a code tester (12).

2. Decoder according to Claim 1, **characterized in that** the code tester (12) is in the form of a parity tester.

3. Decoder according to one of the preceding claims, **characterized in that** the code testers (12) have a level converter (11) arranged upstream, **in that** the level converter (11) considers the input signal to be low below a prescribed voltage range and to be high above the prescribed voltage range ΔV₁₁, **in that** the level converter (11) transfers a low signal or a high signal to the code tester (12) as output signal, **in that** the gates (13) understand a signal to be low below a prescribed voltage range ΔV₁₃ and to be high above the prescribed voltage range ΔV₁₃, and **in that** the voltage range ΔV₁₁ of the level converters and the voltage range ΔV₁₃ of the gates (13) do not overlap.

4. Decoder according to Claim 3, **characterized in that** the level converters (11) are in the form of inverters.

## Revendications

1. Décodeur qui commande une ligne de sortie (3) à partir de signaux (A₁ ... Aₖ) appliqués à des lignes d'adresses (2), les signaux (A₁ ... Aₖ) appliqués aux lignes d'adresses étant en partie des signaux inversés (Â₁ ... Âₖ) et en partie non inversés (A₁ ... Aₖ) appliqués à une porte (13),
**caractérisé en ce que**
les signaux inversés (Âᵢ ... Âₖ) et non inversés (A₁ ... Aₖ) sont vérifiés chaque fois par un contrôleur de code (12).

2. Décodeur selon la revendication 1,
**caractérisé en ce que**
le contrôleur de code (12) est un contrôleur de parité.

3. Décodeur selon l'une des revendications précédentes,
**caractérisé en ce que**
les contrôleurs de code (12) sont précédés par un convertisseur de niveau (11),
ce convertisseur de niveau (11) considère qu'en dessous d'une plage de tension prédéterminée le signal d'entrée est de niveau bas, et qu'au-dessus de la plage de tension prédéterminée (ΔV₁₁) il est de niveau haut, le convertisseur de niveau (11) transmet le signal de sortie comme signal de niveau haut ou de niveau bas au contrôleur de code (12),
la porte (13) en dessous d'une plage de tension prédéterminée (ΔV₁₃) considère un signal comme de niveau bas et au-dessus de la plage de tension prédéterminée (ΔV₁₃) le considère comme de niveau haut, et
la plage de tension (ΔV₁₁) du convertisseur de niveau et la plage de tension (ΔV₁₃) de la porte (13) ne se chevauchent pas.

4. Décodeur selon la revendication 3,
**caractérisé en ce que**
les convertisseurs de niveau (11) sont des inverseurs.
